# EUROPEAN PATENT SPECIFICATION

(11) **EP 2 717 325 B1**
(45) Date of publication and mention of the grant of the patent: **04.04.2018**
(21) Application number: 12793356.2
(22) Date of filing: 31.05.2012
(51) Int. Cl.: H01L 31/04, H01L 31/068, H01L 31/05, H01L 31/0224, H01L 31/18

(54) **SOLAR CELL AND METHOD FOR MANUFACTURING A SOLAR CELL**
SOLARZELLE UND VERFAHREN ZUR HERSTELLUNG EINER SOLARZELLE
CELLULE SOLAIRE ET PROCÉDÉ DE FABRICATION D'UNE CELLULE SOLAIRE

(30) Priority: 31.05.2011 JP 2011121875; 29.07.2011 JP 2011167060
(43) Date of publication of application: 09.04.2014
(73) Proprietor: Kyocera Corporation, Kyoto 612-8501 (JP)
(72) Inventor: TESHIMA, Ryota, Higashiomi-shi Shiga 527-8555 (JP); UMEDA, Kotaro, Higashiomi-shi Shiga 527-8555 (JP); SUGAWARA, Shin, Higashiomi-shi Shiga 527-8555 (JP)
(74) Representative: Viering, Jentschura & Partner mbB Patent- und Rechtsanwälte
(86) International application number: PCT/JP2012/064197
(87) International publication number: WO 2012/165590

(56) References cited:
- EP-A2- 2 299 496
- WO-A1-92/05587
- JP-A- 2006 041 309
- JP-A- 2007 214 372
- JP-A- 2008 159 997
- JP-A- 2008 252 147
- JP-A- 2009 016 713
- JP-A- 2009 088 540
- JP-A- 2009 141 381
- JP-A- 2011 066 424

## Description

### Technical Field

The present invention relates to a solar cell and a method of manufacturing the solar cell.

### Background Art

In order to reduce the amounts of expensive materials such as silver used in electrodes of solar cells; as in WO 92/05587 comprising silver containing contact pads for soldering copper conductor strips; and to enhance the adhesive force between an electrode and a semiconductor substrate, it is proposed, for example, a method of manufacturing a solar cell (see, e.g., Japanese Unexamined Patent Application Publication No. 5-326990), wherein the method includes a step of applying a silver paste to the periphery of the back surface of a silicon substrate constituting a solar cell in a region for connecting a lead frame thereto and drying the paste, a step of applying an aluminum paste to the back surface in such a manner that the aluminum paste overlaps a part of the silver paste in the region for connecting a lead frame thereto and drying the paste, and a step of forming a back surface field (BSF) layer and a pad silver electrode by firing. In this respect, EP2299496A2 describes forming local contact area(s) of a substrate of an electrical component comprising contacting the substrate, on the contact side, with a sintered porous layer comprising aluminum; and compacting and/or removing the sintered porous layer in the contact area to be formed by concentrated electromagnetic radiation.

### Summary of Invention

### Technical Problem

Unfortunately, the conventional method is insufficient for preparing solar cells having high reliability, and there is a demand for an excellent solar cell having certainly enhanced adhesive force between an electrode and a semiconductor substrate while reducing the amount of an electrode material such as silver.

Accordingly, it is an object of the present invention to provide a solar cell that certainly allows a reduction in the amount of an electrode material such as silver and has good reliability and other properties and a method of manufacturing the solar cell.

### Solution to Problem

The invention provides a solar cell and a method of manufacturing a solar cell according to the independent claims. Further embodiments of the invention are described in the dependent claims. The solar cell according to an embodiment of the present invention includes a semiconductor substrate, a back-side electrode arranged in a region excluding at least a predetermined conductor arrangement region in the back surface of the semiconductor substrate, and solder adhering to the back surface of the semiconductor substrate in the conductor arrangement region and to the back-side electrode.

The method of manufacturing a solar cell according to an embodiment of the present invention includes preparing a semiconductor substrate, forming a back-side electrode having an empty portion through which the back surface of the semiconductor substrate is exposed in a region excluding at least a predetermined conductor arrangement region in the back surface of the semiconductor substrate, and soldering in the empty portion by bringing solder into contact with the back surface of the semiconductor substrate exposed in the empty portion and with the back-side electrode and performing ultrasonic soldering for adhesion of the solder to the back surface of the semiconductor substrate exposed in the empty portion and the back-side electrode. Advantageous Effects of Invention

In the solar cell having the above-described structure and the method of manufacturing the solar cell, the solder directly adheres to the semiconductor substrate. Consequently, the amount of the electrode material is certainly reduced, and the adhesive force between the solder and the semiconductor substrate is increased to provide a solar cell having high reliability. In addition, even in a case of providing a wiring conductor on the solder, the adhesion between the wiring conductor, the solder, and the semiconductor substrate can be enhanced to provide a solar cell having high reliability.

### Brief Description of Drawings

Fig. 1 is a schematic plan view of an example of the solar cell according to an embodiment of the present invention viewed from the light-receiving surface side.
Fig. 2 is a schematic plan view of an example of the solar cell according to an embodiment of the present invention viewed from the non-light-receiving surface side.
Fig. 3 is a schematic cross-sectional view of an example of the solar cell according to an embodiment of the present invention, taken along line A-A in Fig. 1.
Fig. 4 is a perspective view schematically illustrating an example of the solar cell according to an embodiment of the present invention.
Figs. 5A to 5C are each a perspective view schematically illustrating an example of the method of manufacturing a solar cell according to an embodiment of the present invention.
Figs. 6A to 6C are each a schematic cross-sectional view on a magnified scale illustrating an example of a part of the solar cell according to an embodiment of the present invention.
Fig. 7 is a schematic plan view illustrating a modification of the conductor arrangement region.
Figs. 8A and 8B include views schematically illustrating a modification of the conductor arrangement region, wherein Fig. 8A is a perspective view, and Fig. 8B is a plan view showing the portion A in Fig. 8A on a magnified scale.
Fig. 9 is a schematic plan view illustrating a modification of the conductor arrangement region.
Fig. 10 is a schematic plan view illustrating a modification of the conductor arrangement region.
Figs. 11A and 11B are perspective views schematically illustrating a modification of the wiring conductor.
Fig. 12 is a schematic cross-sectional view illustrating a modification of the wiring conductor.
Fig. 13 is a perspective view schematically illustrating a modification of the wiring conductor.
Fig. 14 is a schematic plan view of an example of the solar cell according to an embodiment of the present invention viewed from the back surface side.
Fig. 15 is a schematic cross-sectional view on a magnified scale showing an example of a part of the solar cell according to an embodiment of the present invention.
Fig. 16 is a schematic plan view of an example of the solar cell according to an embodiment of the present invention viewed from the non-light-receiving surface side.
Figs. 17A and 17B are schematic cross-sectional views on a magnified scale each showing examples of a part of the solar cell according to an embodiment of the present invention.
Fig. 18 is a partial cross-sectional view schematically illustrating the non-light-receiving surface side of an example of the solar cell according to an embodiment of the present invention.
Figs. 19A to 19C include partial cross-sectional views each schematically illustrating an example of the solar cell according to an embodiment of the present invention having a structure that makes solder penetrate into the electrode material on the non-light-receiving surface side of the solar cell and be brought into direct contact with the semiconductor substrate.
Fig. 20 is a cross-sectional view schematically illustrating an example of the method of manufacturing a solar cell according to an embodiment of the present invention.
Fig. 21 is a perspective view schematically illustrating an example of the method of manufacturing a solar cell according to an embodiment of the present invention.
Fig. 22 is an exploded perspective view schematically illustrating an example of the solar cell according to an embodiment of the present invention.

### Embodiments for Carrying out of the Invention

A solar cell and a method of manufacturing the solar cell according to an embodiment of the present invention will now be described in detail with reference to the drawings. Since the drawings are schematically shown, for example, the size ratio and positional relationship in each configuration shown in the drawings are not necessarily exact.

### <Basic configuration of solar cell>

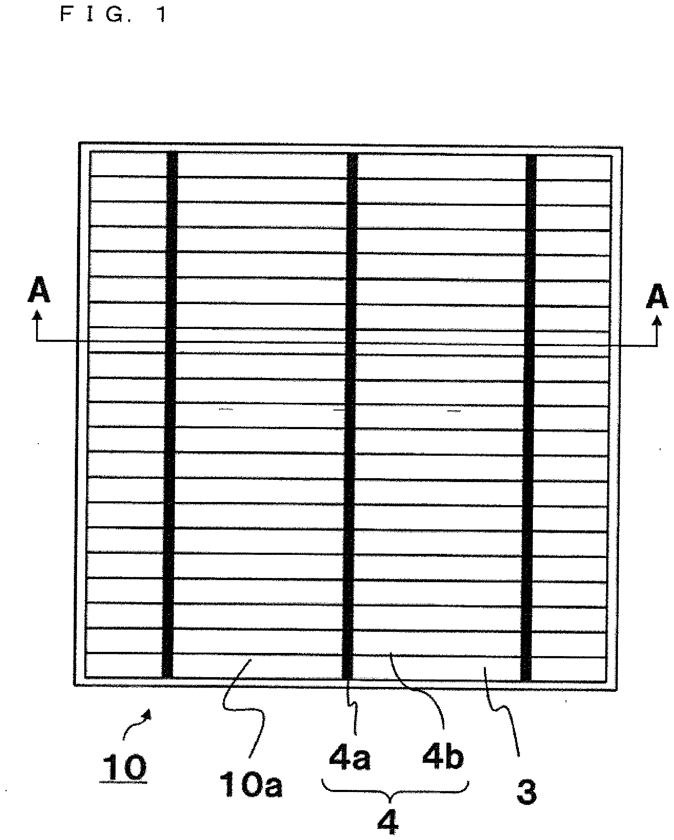

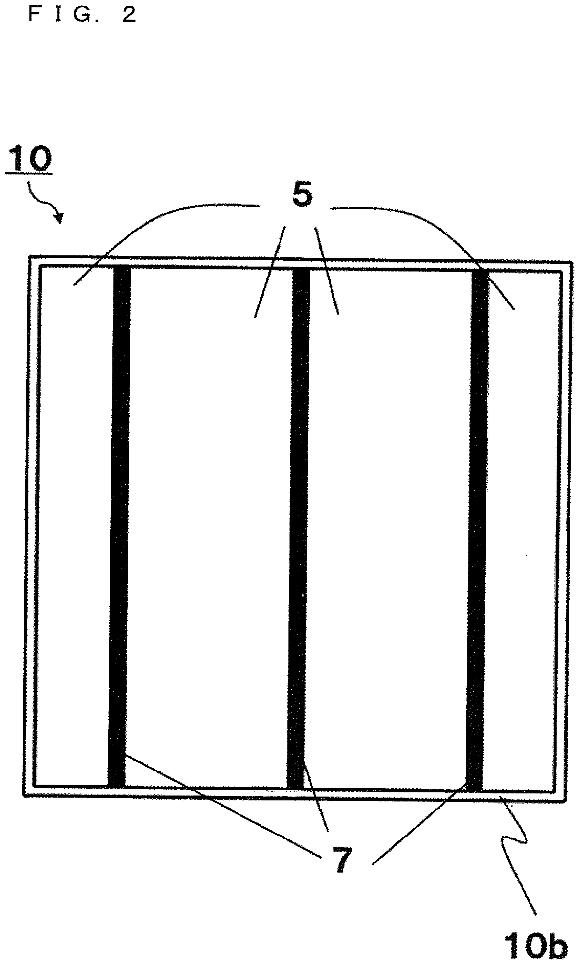

A basic configuration of the solar cell will now be described. As shown in Figs. 1 to 3, the solar cell 10 includes a light-receiving surface (hereinafter referred to as first surface) 10a through which light enters and a non-light-receiving surface (hereinafter referred to as second surface) 10b which is the back surface located in the opposite side of the first surface 10a. The solar cell 10 includes, for example, a tabular semiconductor substrate 9. The semiconductor substrate 9 is constituted of, for example, a first semiconductor portion 1 being a one conductivity type semiconductor region and a second semiconductor portion 2 being a reverse conductivity type semiconductor region disposed on the first surface 10a side of the first semiconductor portion 1. The solar cell 10 includes a semiconductor substrate 9, a second electrode 5 being a back-side electrode arranged on the back surface of the semiconductor substrate 9 in a region excluding at least a predetermined conductor arrangement region 8, and solder 7 adhering to the back surface of the semiconductor substrate 9 in the conductor arrangement region 8 and the second electrode 5.

Here, the conductor arrangement region 8 refers to a portion where at least the conductive solder 7 is in contact with the semiconductor substrate 9 on the second surface 10b side of the solar cell 10 and where a wiring conductor such as a lead frame can be arranged.

The solder 7 and the semiconductor substrate 9 are strongly bonded to each other by, for example, ultrasonic soldering using ultrasonic vibration. In particular, in the ultrasonic soldering not requiring a flux, for example, the removal of oxides present on the surface of the semiconductor substrate 9 is enhanced to strongly bond the solder 7 to the semiconductor substrate 9. Thus, the ultrasonic soldering does not require a flux causing corrosion, etc. and can strongly bond the solder 7 to the semiconductor substrate 9.

The solar cell 10 includes an antireflection layer 3 on the first surface 10a side of the semiconductor substrate 9 and further includes a first electrode 4 serving as a frontside electrode on the first surface 10a side of the semiconductor substrate 9.

The first semiconductor portion 1 is preferably a crystalline silicon substrate, such as a monocrystalline silicon substrate or a polycrystalline silicon substrate having a one conductivity type (e.g., p-type), containing, for example, a predetermined dopant element (impurity element for conductivity type control). The first semiconductor portion 1 preferably has, for example, a thickness of 250 µm or less and more preferably 150 µm or less. The first semiconductor portion 1 may have any shape and has preferably, as shown in the drawings, a quadrangular shape in a planar view from the viewpoints of manufacturing and constituting a solar cell module by aligning a large number of solar cell elements.

The semiconductor substrate 9 is preferably a crystalline material, of which main component is silicon, containing 50% by mass or more of silicon or may be a semiconductor material other than the crystalline silicon. For example, a thin-film silicon based material (containing at least one of amorphous silicon and microcrystalline silicon) or a semiconductor material such as silicon-germanium based material can be used as the semiconductor substrate 9. The use of crystalline silicon as the semiconductor substrate 9 makes fabrication of the semiconductor substrate 9 easy and is preferred from the viewpoints of manufacturing cost, photoelectric conversion efficiency and the like.

The solar cell 10 may have a configuration further at least including a wiring conductor described below on the solder 7. In such a case, the adhesion between the wiring conductor 11, the solder 7, and the semiconductor substrate 9 can be enhanced by employing, for example, ultrasonic soldering to provide a solar cell having high reliability. The solar cell 10 is not limited to double-sided electrode type solar cells extracting output from both the first surface 10a and the second surface 10b. The term "solar cell" not only simply refers to a solar cell element but also includes a solar cell module having a structure in which one or more solar cell elements are sealed on a support substrate with an appropriate sealing material.

### <Specific examples of solar cell>

Specific examples of the solar cell will now be described. An example using a crystalline silicon substrate having a p-conductivity type will be described. When the first semiconductor portion 1 made of crystalline silicon is a p-type, the dopant element is preferably, for example, boron or gallium.

The second semiconductor portion 2 is a layer having a conductivity type opposite to that of the first semiconductor portion 1 and is disposed on the first surface 10a side of the first semiconductor portion 1. That is, the second semiconductor portion 2 is formed in the surface layer of the semiconductor substrate 9. If the first semiconductor portion 1 is a p-conductivity type silicon substrate, the second semiconductor portion 2 is formed so as to be an n-conductivity type. In contrast, if the first semiconductor portion 1 is an n-conductivity type silicon substrate, the second semiconductor portion 2 is formed so as to be a p-conductivity type. In addition, a pn junction portion is formed between the p-conductivity type region and the n-conductivity type region. When the second semiconductor portion 2 is a p-conductivity silicon substrate, for example, the second semiconductor portion 2 can be formed by diffusing impurities such as phosphorus to the side becoming the first surface 10a of the silicon substrate.

The antireflection layer 3 reduces the reflectance of light within a desired wavelength region and increases the amount of light-generating carriers and can therefore improve a photoelectric current density Jsc of the solar cell element 10. Examples of the antireflection layer 3 include silicon nitride films, titanium oxide films, silicon oxide films, magnesium oxide films, indium tin oxide films, tin oxide films, and zinc oxide films. The thickness of the antireflection layer 3 is appropriately selected depending on the material used such that non-reflection conditions for appropriate incident light are achieved. For example, when the semiconductor substrate 9 is made of silicon, the antireflection layer 3 preferably has a refractive index of about 1.8 to 2.3 and a thickness of about 500 to 1200 Å. Furthermore, when a silicon nitride film is used as an antireflection layer 3, the silicon nitride film can also provide a passivation effect and is therefore preferred as the antireflection layer 3.

The second surface 10b side of the first semiconductor portion 1 is provided with a BSF region 6 at a portion on which a second electrode 5 is formed. The BSF region 6 has a function of reducing a reduction in efficiency due to recombination of minority carriers near the second surface 10b of the first semiconductor portion 1 and forms an internal electric field on the second surface 10b side of the first semiconductor portion 1. The BSF region 6 has the same conductivity type as that of the first semiconductor portion 1 and contains a dopant element in a higher concentration than the concentration of majority carriers contained in the first semiconductor portion 1. That is, when the first semiconductor portion 1 is a p-type, the BSF region 6 is a p⁺ semiconductor region having a higher impurity concentration. The BSF region 6 is preferably formed by, for example, diffusing a dopant element such as boron or aluminum to the second surface 10b side such that the concentration of the dopant element is about 1×10¹⁸ to 5×10²¹ atoms/cm³.

As shown in Fig. 1, the first electrode 4 includes a bus bar electrode 4a as an output extraction electrode and finger electrodes 4b as a plurality of linear collector electrodes. At least a part of bus bar electrode 4a intersects with the finger electrodes 4b. The bus bar electrode 4a has, for example, a width of about 1.3 to 2.5 mm, whereas the finger electrodes 4b are each in the form of a line having a width of about 50 to 200 µm, narrower than the bus bar electrode 4a. The finger electrodes 4b are a plurality of linear electrodes disposed with a space of about 1.5 to 3 mm between each two. The thickness of such a first electrode 4 is about 10 to 40 µm. The first electrode 4 can be formed by applying a conductive paste containing a metal material having good conductivity, such as silver, in a desired shape by, for example, screen printing and then firing the paste.

The second electrode 5 has a thickness of about 1 to 40 µm and is disposed on substantially the entire surface on the second surface 10b side of the first semiconductor portion 1. The second electrode 5 can be formed by applying a conductive paste mainly made of, for example, silver or aluminum to the surface and firing the paste or by forming a film by using sputtering method or vapor deposition method. The second electrode 5 including a conductive layer is electrically connected to the first semiconductor portion 1 via the BSF region 6.

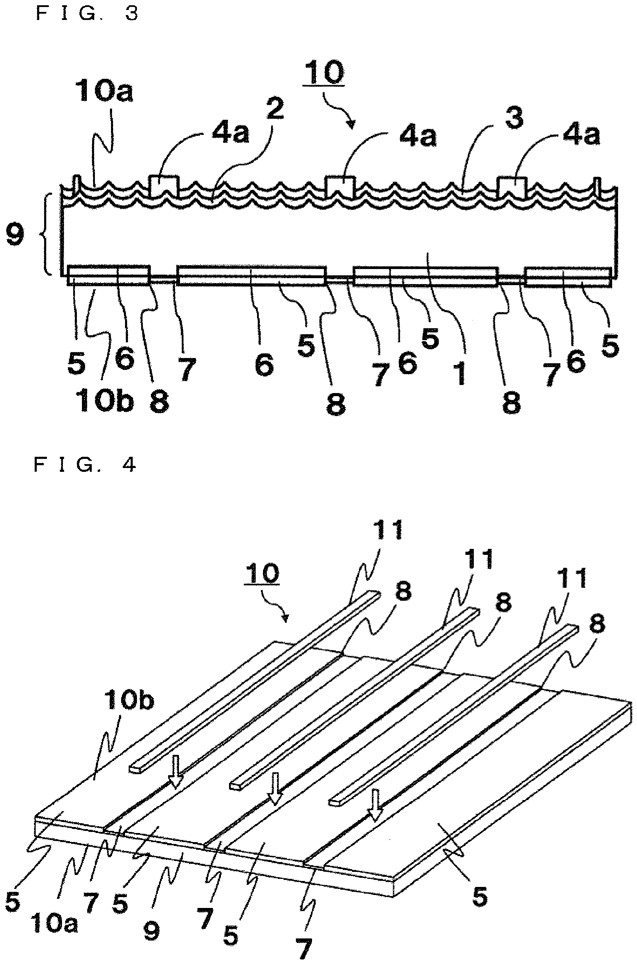

As shown in Fig. 3, the solar cell 10 at least includes solder 7 on the second surface 10b side. In this embodiment, since the electrode material such as silver is not used for connecting between the wiring conductor 11 and the solar cell, even if a sealing material is used, corrosion due to the acid from the sealing material can be inhibited, and a warp due to the electrode material can also be inhibited. In the case of using aluminum as the second electrode 5, a broad BSF region 6 can be formed by broadening the region to which aluminum is applied. For example, when an electrode material such as silver is disposed in the region for providing the solder 7, it is difficult to broaden the region to which aluminum is applied by disposing a conductor arrangement region having a width of, for example, about 2 to 4 mm and arranging electrode material such as silver in the conductor arrangement region for securing an adhesive strength between the electrode material and the semiconductor substrate 9. Since the adhesive strength between the semiconductor substrate 9 and the solder is higher than that between the semiconductor substrate 9 and the electrode material such as silver, when an adhesive strength equivalent to that in the above-mentioned case is achieved, for example, the region to which aluminum is applied can be broadened by reducing the width of the conductor arrangement region 8.

In addition, for example, the solder 7 may be bonded to the side surface of the second electrode 5 facing the conductor arrangement region 8, without adhering to the upper surface of the second electrode 5. In this case, since the upper surface of the second electrode 5 is not covered with the solder 7, it is possible to reduce the volume of the solder 7 and to thereby reduce the influence of thermal contraction of the solder 7 on the solar cell 10. Consequently, the warp of the solar cell 10 can be decreased to provide a solar cell 10 having high reliability.

Alternatively, for example, the solder 7 may adhere to both the upper surface of the second electrode 5 and the side surface of the second electrode 5 facing the conductor arrangement region 8. In this case, since the solder 7 covers the upper surface of the second electrode 5, the contact area between the second electrode 2 and the semiconductor substrate 9 can be broadened, which is advantageous to solar cell characteristics.

The solder 7 may have any composition, and the composition preferably includes an alloy of tin and lead or an alloy of tin and zinc. When the solder 7 is an alloy of tin and lead, the mass ratio, tin : lead, is preferably 60 to 80 : 20 to 40 and the alloy preferably contains about 1 to 20% by mass of antimony based on the total amount (100% by mass) of the alloy. When the solder 7 is an alloy of tin and zinc, the mass ratio, tin : zinc, is preferably 80 to 99.9 : 0.1 to 20 and the alloy preferably contains about 1 to 2% by mass of antimony based on the total amount (100% by mass) of the alloy.

The solder 7 may contain an alloy of tin, silver, and bismuth. When the solder 7 is an alloy of tin, silver, and bismuth, the mass ratio, tin : silver : bismuth is preferably 78 to 99 : 0.1 to 20 : 0.1 to 10.

The solder 7 may contain an alloy of tin, silver, and copper. When the solder 7 is an alloy of tin, silver, and copper, the mass ratio, tin : silver : copper, is preferably 78 to 99 : 0.1 to 10 : 0.1 to 10.

The solder 7 may contain tin and aluminum or gallium or indium. When the solder 7 has such a composition, the p-type dopant element diffuses into the first semiconductor portion 1 to inhibit a reduction in efficiency due to recombination of carriers near the second surface 10b of the first semiconductor portion 1.

The solder 7 is preferably a material not containing lead, such as tin-zinc-antimony based solder, out of consideration for the environment.

The second electrode 5 is mainly made of aluminum (60% by mass or more), and at the junction of the solder 7 and the second electrode 5, an alloy layer containing solder components and aluminum is present. This alloy layer can advantageously reduce the contact resistance between the solder 7 and the second electrode 5. In addition, ultrasonic soldering can remove oxide films formed on the surfaces of the solder 7 and the second electrode 5 to allow the alloy layer to be readily formed.

The conductor arrangement region 8 may be provided with a plurality of penetration portions that allow exposure of the semiconductor substrate 9 at a plurality of positions. The conductor arrangement region 8 may include a long region extending from one end of the semiconductor substrate 9 or the second electrode 5 to a predetermined position in a planar view on the back surface of the semiconductor substrate 9 covered with the solder 7. Alternatively, the conductor arrangement region 8 may be a long region extending from one end to the other end of the semiconductor substrate 9 in a planar view on the back surface of the semiconductor substrate 9 covered with the solder 7. Here, when the width of the conductor arrangement region 8 at the portion on one end side of the semiconductor substrate 9 is broader than that of another portion, the adhesion between the wiring conductor 11 described below, which is arranged at a broader portion, and the semiconductor substrate 9 is advantageously improved.

As shown in Fig. 4, when the solar cell 10 includes a wiring conductor 11 on the solder 7, the surface of the wiring conductor 11 may be covered with solder having the above-mentioned composition with a thickness of about 5 to 100 µm. On this occasion, though the solder may have any composition, the above-mentioned composition can improve the bond between the solder 7 and the wiring conductor 11. Consequently, the wiring conductor 11 can strongly bond to the solder 7. In addition, the wiring conductor 11 may be metal foil, such as copper or aluminum foil, having a thickness of about 0.1 to 0.8 mm.

The solder 7 should have a melting point higher than that of the solder covering the surface of the wiring conductor 11. By doing so, even if a case of bonding the wiring conductor 11 to the solder 7 at a high temperature such as 255°C or more and 305°C or less, the solder 7 on the semiconductor substrate 9 side does not melt. Consequently, the adhesion between the wiring conductor 11 and the semiconductor substrate 9 is improved.

In a case of disposing the first electrode 4 on the first surface 10a side of the solar cell 10, the first electrode 4 is preferably arranged so as to overlap the wiring conductor 11 in a planar perspective view.

### <Method of manufacturing solar cell>

A method of manufacturing the solar cell 10 will now be described.

First, a basic method of manufacturing a solar cell according to this embodiment will be described. In the embodiment, at least the following steps are sequentially carried out.

A substrate-preparing step for preparing a semiconductor substrate 9 is carried out. Subsequently, a back-side electrode-forming step for forming a second electrode 5 on the second surface 10b of the semiconductor substrate 9 is carried out, where the second electrode 5 has an empty portion serving as a conductor arrangement region 8 for exposing the semiconductor substrate 9. Furthermore, an adhesion step for bonding solder 7 to the inside of the empty portion by bringing solder 7 into contact with the semiconductor substrate 9 exposed in the empty portion and with the second electrode 5 and bonding the solder to them by ultrasonic soldering in the empty portion.

In this adhesion step, the solder may adhere to the inside of the empty portion by arranging the wiring conductor 11 in the empty portion, then bringing the solder into contact with the wiring conductor 11 such as a lead frame, the semiconductor substrate 9 exposed in the empty portion and the second electrode 5 and bonding the solder to them by ultrasonic soldering.

In the adhesion step, metal foil such as copper or aluminum foil may be used as the wiring conductor 11, or metal foil, such as copper foil, covered with solder having the above-mentioned composition may be used.

A specific example of the method of manufacturing the solar cell 10 will now be described. First, the substrate-preparing step for preparing the semiconductor substrate 9 will be described. When a monocrystalline silicon substrate is used as the first semiconductor portion 1 mainly constituting the semiconductor substrate 9, the substrate is produced by, for example, a Czochralski method, whereas when a polycrystalline silicon substrate is used as the first semiconductor portion 1, the substrate is produced by, for example, casting process. An example of using p-type polycrystalline silicon as the substrate, which is first prepared, will now be described.

First, a p-type polycrystalline silicon ingot is prepared by, for example, casting process. Then, the ingot is sliced into a substrate having a thickness of 250 µm or less for example. Subsequently, in order to clean the mechanically damaged layer and the contaminated layer of sections of this substrate, the surfaces are desirable to be slightly etched with a solution of, for example, NaOH, KOH, hydrofluoric acid, or fluonitric acid. Furthermore, after this etching step, a finely roughened structure is desirably further formed on the surface of the substrate by wet etching method. The step of removing the damaged layer can be omitted by performing the wet etching. Thus, a semiconductor substrate 9 including a first semiconductor portion 1 can be prepared.

Subsequently, an n-type second semiconductor portion 2 is formed on the first surface 10a side of the first semiconductor portion 1. The second semiconductor portion 2 is formed by, for example, a thermal diffusion method in which P₂O₅ in a paste state is applied to the surface of the first semiconductor portion 1 and is thermally diffused, a vapor-phase thermal diffusion method using phosphorus oxychloride (POCl₃) in a gas state as a diffusion source, or an ion implantation method in which phosphorus ions are directly diffused. The second semiconductor portion 2 is formed so as to have a depth of about 0.2 to 2 µm and a sheet resistance of about 60 to 150 Ω/□. The method of forming the second semiconductor portion 2 is not limited to the above. For example, a hydrogenated amorphous silicon film or a crystalline silicon film such as a microcrystalline silicon film may be formed by a thin-film forming technique. Furthermore, an i-type silicon region may be formed between the first semiconductor portion 1 and the second semiconductor portion 2.

Subsequently, when the second semiconductor portion 2 is formed on the second surface 10b side of the first semiconductor portion 1, a p-type conductivity region may be exposed by etching only the second surface 10b side. For example, only the second surface 10b side of the first semiconductor portion 1 is immersed in a fluonitric acid solution to remove the second semiconductor portion 2. Subsequently, phosphorus glass adhered to the surface of the first semiconductor portion 1 when the second semiconductor portion 2 is formed is removed by etching. The phosphorus glass remaining in the removal of the second semiconductor portion 2 formed on the second surface 10b side functions as an etching mask. Consequently, the second semiconductor portion 2 on the first surface 10a side is inhibited from being removed or being damaged.

As a result, a semiconductor substrate 9 provided with a first semiconductor portion 1 including a p-type semiconductor region and a second semiconductor portion 2 can be prepared.

Subsequently, an antireflection layer 3 is formed. The antireflection layer 3 is formed by, for example plasma enhanced chemical vapor deposition (PECVD) method, vapor deposition method, or sputtering method. For example, in a case of forming a silicon nitride film as the antireflection layer 3 by PECVD, a gas mixture of silane (SiH₄) and ammonia (NH₃) is diluted with nitrogen (N₂) gas in a reaction chamber at about 500°C, and the gas is transformed into plasma by grow discharge decomposition to deposit silicon nitride as the antireflection layer 3.

Subsequently, a first electrode 4 (bus bar electrode 4a and finger electrode 4b) and a second electrode 5 are formed as follows.

The first electrode 4 is produced from a silver paste containing a metal powder comprised of, for example, silver, an organic vehicle and glass frit. The silver paste is applied onto the first surface of the semiconductor portion 1 and is fired at a maximum temperature of 600°C to 850°C for about several tens of seconds to several tens of minutes. The first electrode 4 penetrating the antireflection layer 3 is formed on the first semiconductor portion 1 by a fire through method. The application of the paste can be performed by, for example, screen printing method. In the formation of the first electrode 4, the solvent in the applied silver paste is preferably evaporated at a predetermined temperature for drying.

Formation of the BSF region 6 will be described. For example, an aluminum paste containing an aluminum powder and an organic vehicle is applied to a predetermined region. The application can be performed by, for example, screen printing method. Here, after the application of the paste, it is preferred to dry the paste by evaporating the solvent at a predetermined temperature for avoiding adhesion of the paste to other portions during the work.

Subsequently, the semiconductor substrate 9 is fired in a firing furnace at a maximum temperature of 600°C to 850°C for about several tens of seconds to several tens of minutes to form the BSF region 6 on the second surface 10b side of the first semiconductor portion 1 and an aluminum layer as the second electrode 5 thereon. On this occasion, even in the case of forming the second semiconductor portion 2 on the second surface 10b side, removal of the second semiconductor portion 2 on the second surface 10b side is unnecessary. The pn junction-isolation for isolating the continuous region of the pn junction can be performed by irradiating only the periphery on the first surface 10a side or the second surface 10b side with lasers. The conductor arrangement region 8 is simultaneously formed in the region to which the aluminum paste is not applied.

Next, a method for adhesion of solder 7 to the conductor arrangement region 8 and arrangement of a wiring conductor 11 onto the solder 7 will be described. As an example, a case in which the conductor arrangement region 8 is a long region at which the semiconductor substrate 9 is exposed from one end 5a to the other end 5b of the semiconductor substrate 9 in a planar view will be described.

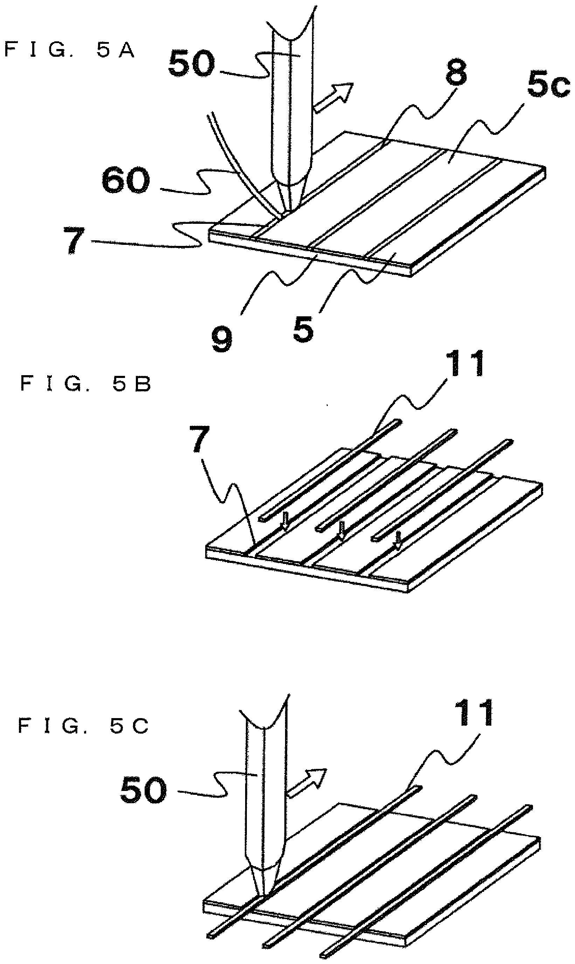

As shown in Fig. 5A, solder wire 60 having the above-mentioned composition is placed on the conductor arrangement region 8, and ultrasonic soldering is applied thereto. The apparatus for the ultrasonic soldering includes a soldering iron 50 comprised of a conventional soldering iron and an ultrasonic wave oscillator equipped to the soldering iron. The soldering iron 50 is movable in the x-, y-, and z-axis directions. In order to allow an appropriate amount of solder from the solder wire 60 to adhere to the conductor arrangement region 8, for example, the ultrasonic oscillation frequency is preferably about 40 to 100 kHz, the ultrasonic oscillation output is preferably about 1 to 15 W, and the temperature is preferably controlled to about 180°C to 450°C. In this occasion, the table on which the semiconductor substrate 9 is placed may be heated in advance to about 50°C to 100°C. If the width of the solder wire 60 and the width of the end of the soldering iron 50 are smaller than the width of the conductor arrangement region 8, the solder 7 can be strongly bonded to the inner wall of the conductor arrangement region 8 without bonding to the upper surface 5c of the second electrode 5. In addition, the ultrasonic soldering can clean the surface of the semiconductor substrate 9 and enhances, for example, removal of oxides such as natural oxide films to allow the solder 7 to strongly bond to the semiconductor substrate 9. In a case of forming the second electrode 5 by firing a conductive paste, the solder molten by ultrasonic soldering penetrates into between metal grains constituting the second electrode 5 to further enhance the removal of the oxides on the surface, which can advantageously reduce the contact resistance between the solder 7 and the second electrode 5. In addition, the ultrasonic soldering forms an alloy layer comprised of the components of the solder 7 and metal grain on the surfaces of the metal grains. The thickness of the solder 7 can be controlled by controlling the distance between the soldering iron 50 and the semiconductor substrate 9, the moving speed of the soldering iron 50, and the input amount of the solder wire 60. For example, the solder 7 has a thickness of about 5 to 40 µm. The soldering iron 50 in the soldering step may be in contact with the second electrode 5 or the semiconductor substrate 9 or in noncontact with them. When the soldering iron 50 moves up and down at the start and the end of the ultrasonic soldering, a protrusion may be generated in the solder 7. On this occasion, the protrusion can be flattened by blowing hot air to the protrusion, resulting in a reduction in occurrence of cracks during conveying.

Here, the solder 7 preferably has a thickness larger than that of the second electrode 5. By doing so, the wiring conductor 11 comes into contact with the solder 7 ahead to reduce the occurrence of cracks.

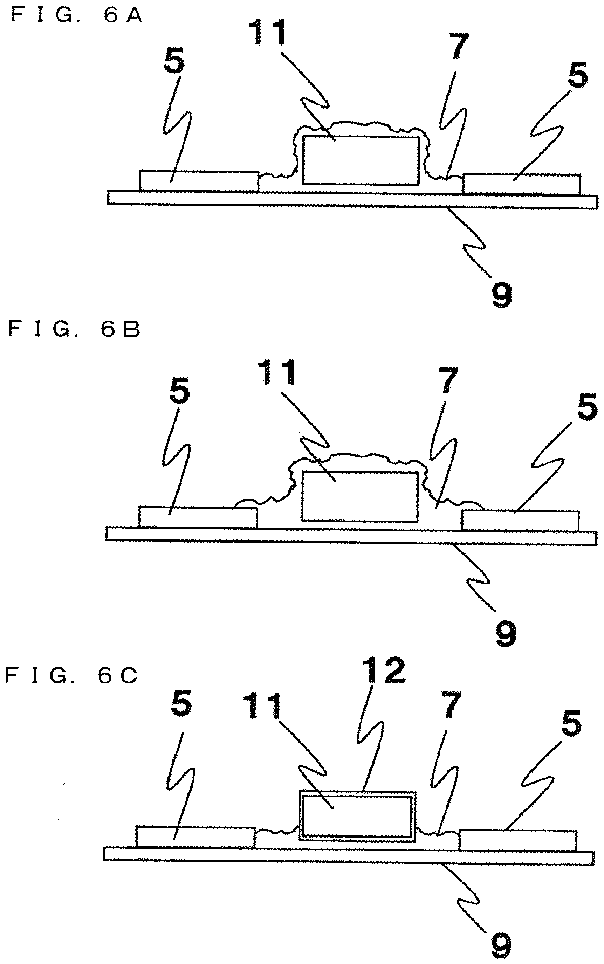

Subsequently, as shown in Fig. 5B, a long wiring conductor 11 is disposed on the solder 7 adhering to the conductor arrangement region 8, and as shown in Fig. 5C, the wiring conductor 11 is directly bonded to the solder 7 by usual soldering or ultrasonic soldering with the soldering iron 50. The side view from one end of the semiconductor substrate 9 on this occasion is as that shown in Fig. 6A. Bonding between the wiring conductor 11 and the solder 7 may be performed by any known soldering method and may be performed using a reflow furnace or hot air.

As shown in Fig. 6B, the solder 7 may be applied so as to bond to the upper surface of the second electrode 5. In this case, when the soldering shown in Fig. 5A or Fig. 5C is performed, the solder 7 may be formed such that the solder 7 covers the upper surface of the second electrode 5. For example, the width of the solder at the end of the iron is set so as to be larger than the width of the conductor arrangement region 8. As a result, the molten solder from the solder wire 60 covers the upper surface of the second electrode 5 near the conductor arrangement region 8 and forms the solder 7. For example, the width of solder at the end of the iron may be about 1 to 5 mm. In a case of the second electrode 5 formed by firing a conductive paste, the solder molten by ultrasonic soldering may penetrate into between metal grains of the second electrode 5 or may penetrate until the middle in the thickness direction from the surface of the second electrode 5. The amount of solder penetrating into the second electrode 5 can be controlled by appropriately controlling the soldering time.

Alternatively, as shown in Fig. 6C, a wiring conductor 11 being a conductor, such as copper foil, covered with solder 12 (solder plating) made of the same material as the solder 7 may be arranged on the solder 7.

As described above, the solar cell element 10 can be produced. As a result, when the wiring conductor 11 and the solar cell 10 are connected to each other, the amount of the electrode material such as silver can be reduced, and the adhesive force between the solder 7 and the semiconductor substrate 9 is enhanced. According to the embodiment, a solar cell having high reliability can be provided. Furthermore, in a case of disposing the wiring conductor 11 on the solder 7, the adhesion between the wiring conductor 11, the solder 7, and the semiconductor substrate 9 is enhanced, resulting in provision of a solar cell having high reliability.

### <Modification example>

The present invention is not limited to the above-described embodiment, and various modifications and changes within the scope of the present invention are possible. A variety of modification examples will now be described.

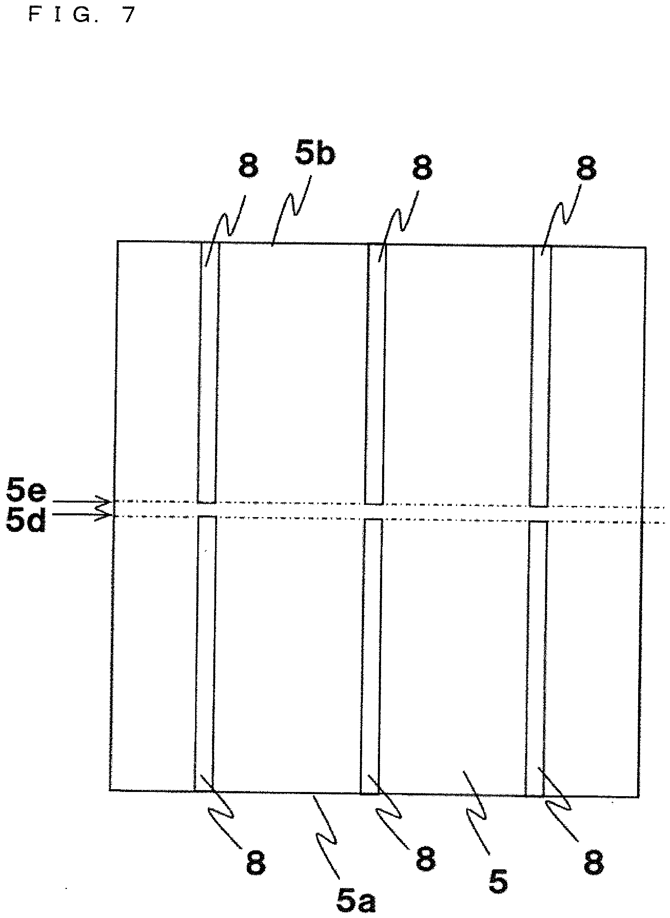

In the embodiment described above, the conductor arrangement region 8 has been described as a long region exposing the semiconductor substrate 9 from one end to the other end of the semiconductor substrate 9 in a planar view. The conductor arrangement region 8 may include, for example, as shown in Fig. 7, a long region exposing the semiconductor substrate 9 from one end 5a to a predetermined position 5d, indicated by an alternate long and short dash line, of the semiconductor substrate 9 in a planar view. Thus, the conductor arrangement region 8 includes a long region exposing the semiconductor substrate 9 from one end 5a to a predetermined position 5d of the semiconductor substrate 9 and a long region exposing the semiconductor substrate 9 from the other end 5b to a predetermined position 5e, indicated by an alternate long and short dash line, of the semiconductor substrate 9 in a planar view. Consequently, the region where the second electrode 5 is formed can be advantageously broadened by the area from the predetermined position 5d to the predetermined position 5e.

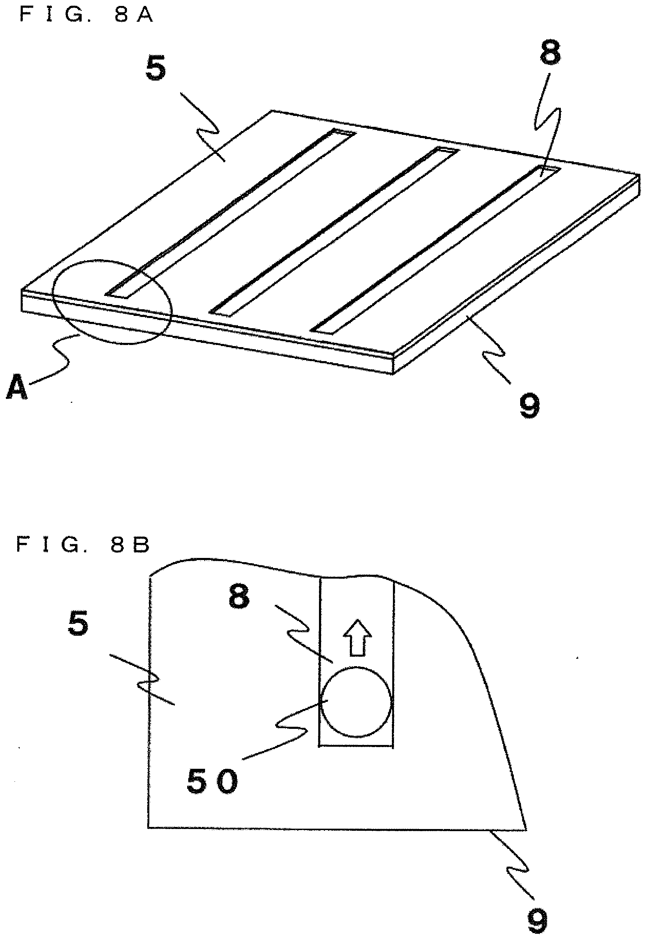

Alternatively, as shown in Fig. 8A, the conductor arrangement region 8 may be a long region from a position near one end of the semiconductor substrate 9 to a position near the other end of the semiconductor substrate 9. In such a case, the second electrode 5 may be also formed at least in a part of the areas from one end or the other end of the semiconductor substrate 9 to the conductor arrangement region 8. In this case, as shown in Fig. 8B, the starting position of ultrasonic soldering is preferably slightly apart from one end of the empty portion. By doing so, the solder is not repelled by the second electrode 5 at the start of ultrasonic soldering, resulting in good adhesion of the solder to the semiconductor substrate 9. The molted solder moves to cover the empty portion. Furthermore, a part of the solder can cover the upper surface of the second electrode 5 at one end of the empty portion by increasing the amount of the solder.

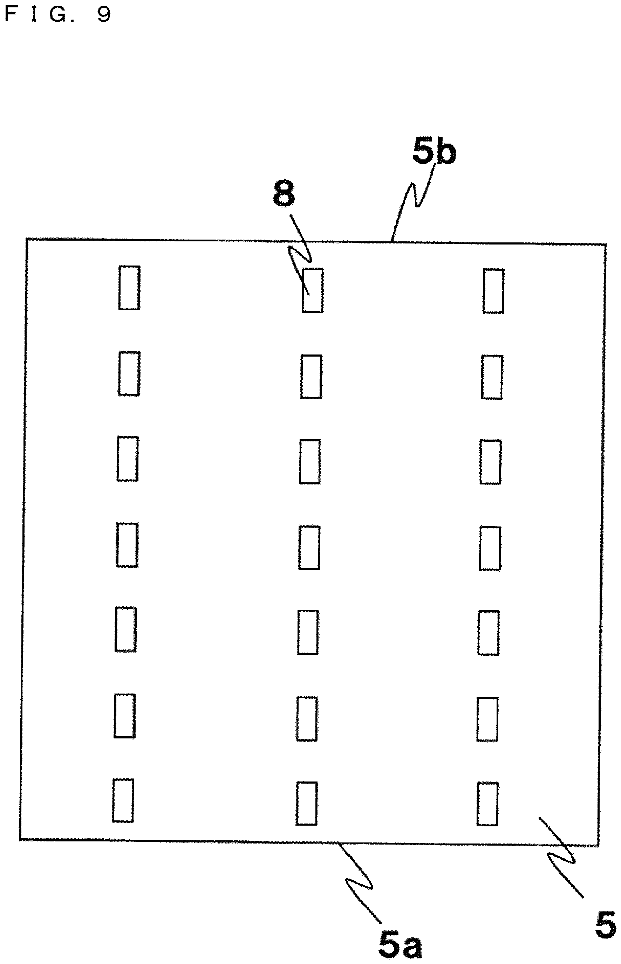

As shown in Fig. 9, the conductor arrangement region 8 may be a region containing a plurality of penetration portions exposing the semiconductor substrate 9 at a plurality of positions. In particular, these penetration portions are preferably aligned in a line from one end to the other end of the semiconductor substrate 9. Such a configuration can advantageously further broaden the region for forming the second electrode 5 than the example shown in Fig. 7. Furthermore, the thermal expansion and contraction of the wiring conductor 11 can be readily released to reduce the warp of the solar cell by applying the solder 7 to the conductor arrangement region 8 only or to the conductor arrangement region 8 and the upper surface of the second electrode 5 in the region near the conductor arrangement region 8 such that the positions of soldering on the wiring conductor 11 are scattered in an island form. The contact resistance between the solder 7 and the second electrode 5 is reduced by forming the solder 7 on the upper surface of the second electrode 5 between penetration portions aligned in line, i.e., on the upper surface of the second electrode 5 being in contact with the wiring conductor 11. As a result, the solar cell characteristics can be improved.

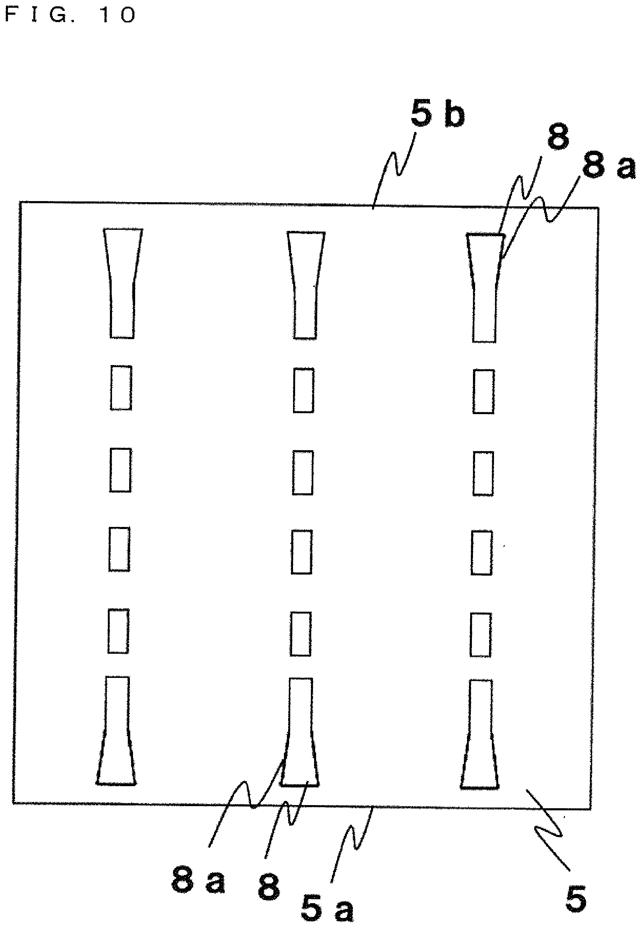

As shown in Fig. 10, in the case of the conductor arrangement region 8 including a plurality of penetration portions, for example, when the portion 8a of the conductor arrangement region 8 positioned on one end side of the semiconductor substrate 9 has a width broader than that of another portion, the adhesion between the solder 7 and the semiconductor substrate 9 arranged at the portion 8a is advantageously increased.

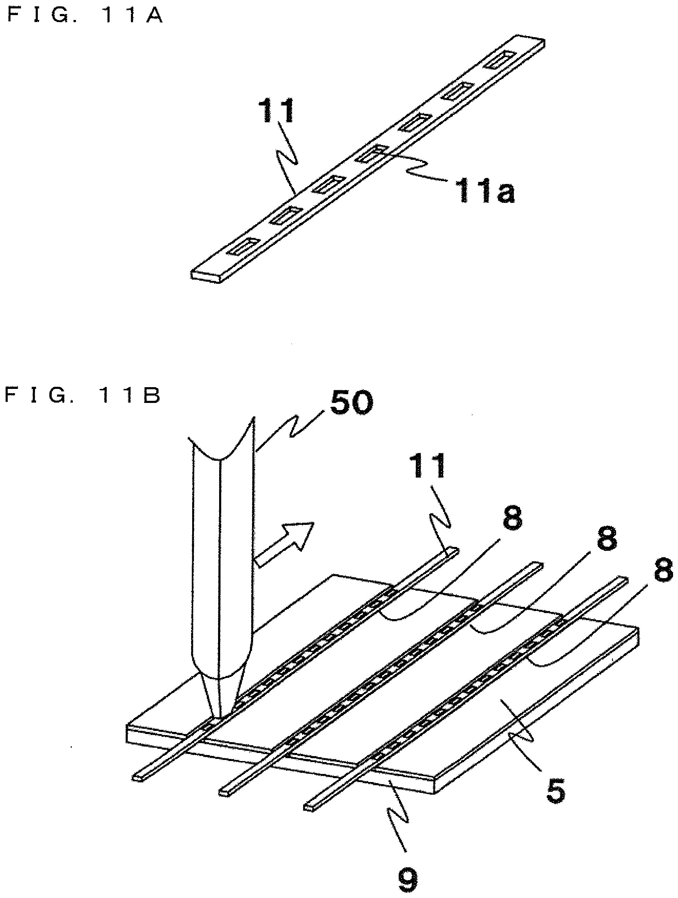

As shown in Fig. 11A, for example, the wiring conductor 11 may be provided with a plurality of through-holes 11a arranged with predetermined intervals in the longitudinal direction of the long wiring conductor 11. In the case of employing such a wiring conductor 11, as shown in Fig. 11B, the wiring conductor 11 is arranged in such a manner that the positions of the through-holes 11a of the wiring conductor 11 are coincident with the positions of the conductor arrangement region 8, and ultrasonic soldering can be carried out while solder wire (not shown) being supplied. Since the solder is supplied to the conductor arrangement region 8 though the through-holes 11a, the solder can bond to both the second electrode 5 and the wiring conductor 11. Thus, adhesion of the solder can be advantageously achieved by a simple process. The surface of the wiring conductor 11 may be covered with the solder. In such a case, since the solder is present on the surface of the through-hole 11a, solder wire 60 is unnecessary. The solder disposed at the surface of the through-hole 11a is supplied to the conductor arrangement region 8 by simple soldering through ultrasonic soldering. As a result, the solder adheres to the second electrode 5, and the molten solder further adheres to the body of the wiring conductor 11 to achieve strong bonding between the wiring conductor 11 and the second electrode 5 via the solder.

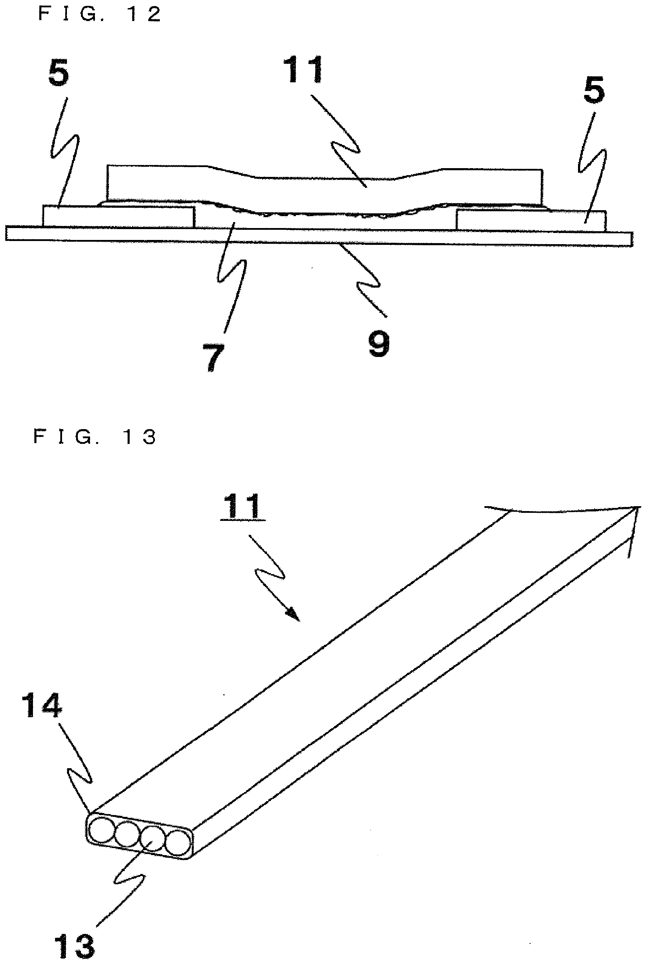

As shown in Fig. 12, the wiring conductor 11 may include a portion having the width (or the length in the short direction) broader than the width (or the length in the short direction) of the conductor arrangement region 8. Alternatively, the wiring conductor 11 may completely cover the conductor arrangement region 8 (or cover the upper surface of the second electrode 5 near the conductor arrangement region 8). In these cases, the solder 7 may cover the upper surface of the second electrode 5 or may adhere to the side surface of the second electrode 5 facing the conductor arrangement region 8 without covering the upper surface of the second electrode 5. In particular, in the case of the wiring conductor 11 completely covering the conductor arrangement region 8, the wiring conductor 11 is in electrical contact with the second electrode 5 to reduce the electric resistance. As a result, the photoelectric conversion efficiency is advantageously improved. Furthermore, the solder 7 may have a width broader than the width of the wiring conductor 11. Such a configuration can reduce the electric resistance and thereby advantageously improves the photoelectric conversion efficiency.

As shown in Fig. 13, the wiring conductor 11 may be an assembly of a plurality of fine wire leads 13 covered with solder 14 by solder dipping technology. In such a wiring conductor 11, a plurality of fine wire leads is not separated into each wire lead. In addition, resistance to bending to the width direction of the wiring conductor 11 is low to reduce the stress on the solar cell 10 to which the wiring conductor 11 is applied, resulting in advantageous reduction of occurrence of, for example, cracks in the solar cell 10.

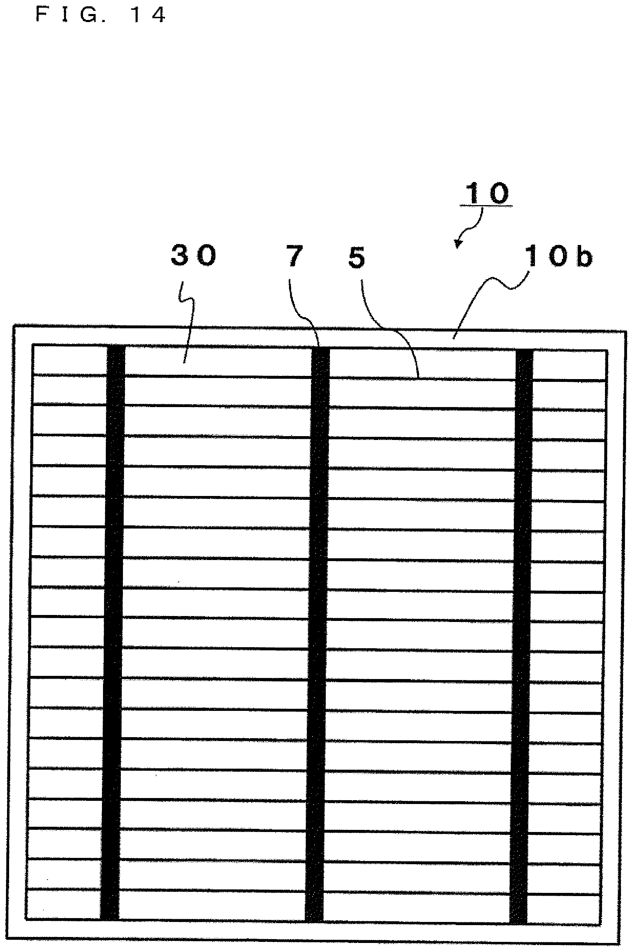

A passivation film may be formed on the second surface 10b side and can also be applied to a case of the second electrode 5 having a grid-like shape as in the first electrode 4. Fig. 14 is a schematic plan view of another example of the solar cell 10 viewed from the second surface 10b side. As shown in Fig. 14, the solar cell 10 includes a passivation film 30 formed on almost the entire surface of the second surface 10b. That is, the passivation film 30 is disposed on the first semiconductor portion 1 on the second surface 10b side. This passivation film 30 can be formed by, for example, atomic layer deposition (ALD) method.

A passivation film 30 made of, for example, aluminum oxide can be formed by ALD method through the following steps. A semiconductor substrate 9 made of, for example, a crystalline silicon described above is placed in a film-forming chamber and the surface temperature of the semiconductor substrate 9 is raised to 100°C to 300°C by heating. Subsequently, an aluminum material such as trimethyl aluminum, together with a carrier gas such as an argon gas or a nitrogen gas, is supplied onto the semiconductor substrate 1 for 0.5 sec to allow the aluminum material to attach to the entire surface of the semiconductor substrate 1 (step 1). Subsequently, the film-forming chamber is purged with, for example, a nitrogen gas for 1.0 sec to remove the spatial aluminum material and also remove a part of the aluminum material adsorbed to the semiconductor substrate 9 except for the aluminum material attached at an atomic layer level (step 2). Subsequently, water or an oxidizing agent such as ozone gas is supplied to the film-forming chamber for 4.0 sec to remove the alkyl group, CH₃, of the trimethyl aluminum as the aluminum material and also oxidize the dangling bond of the aluminum to form an atomic layer of aluminum oxide on the semiconductor substrate 9 (step 3). Subsequently, the film-forming chamber is purged with, for example, a nitrogen gas for 1.5 sec to remove the spatial oxidizing agent and also remove materials other than the aluminum oxide at atomic layer level, such as the oxidizing agent not involved in the reaction (step 4). A passivation film 30 of an aluminum oxide layer having a predetermined thickness can be formed by repeating the steps 1 to 4. In addition, the aluminum oxide layer can readily contain hydrogen by mixing hydrogen into an oxidizing agent used in step 3, resulting in an enhancement in hydrogen passivation effect.

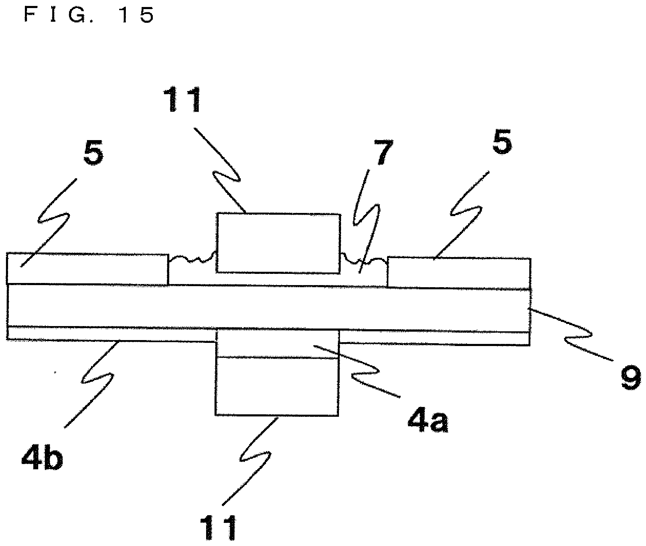

As shown in Fig. 15, when the bus bar electrode 4a is disposed on the first surface 10a side of the solar cell 10, the bus bar electrode 4a is preferably arranged so as to overlap the wiring conductor 11 on the second surface 10b side in a planar perspective view. By doing so, when a plurality of solar cells 10 are linked to one another with the wiring conductor 11, the bus bar electrode 4a and the second electrode 5 can be connected to each other with the wiring conductor 11 in the same straight line with precisely, simply, and quickly.

In the embodiment described above, double-sided electrode type solar cells each extracting the output from both electrodes disposed on the first surface 10a side and the second surface 10b side of the semiconductor substrate 9 have been described. The technology of this embodiment can also be applied to a back-contact type solar cell extracting the output from the electrode disposed on the second surface 10b side.

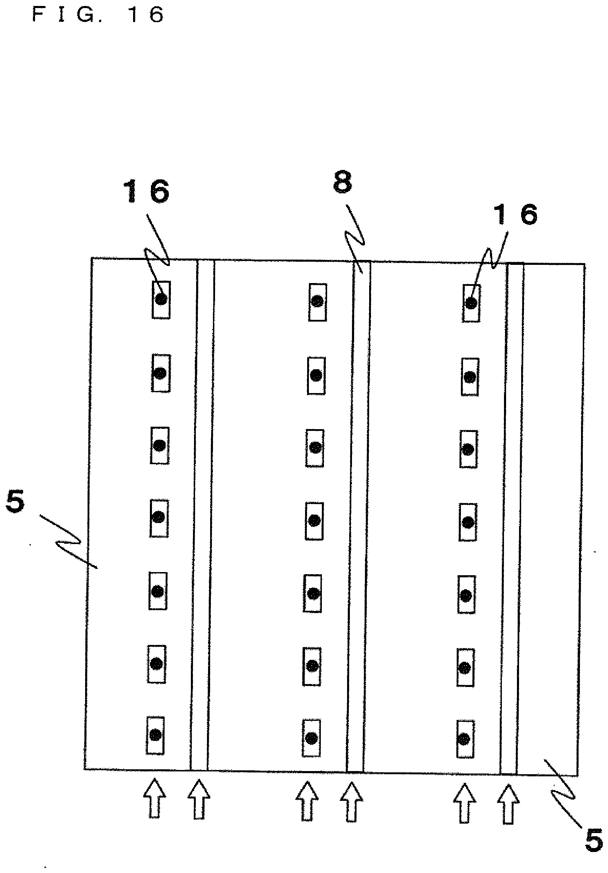

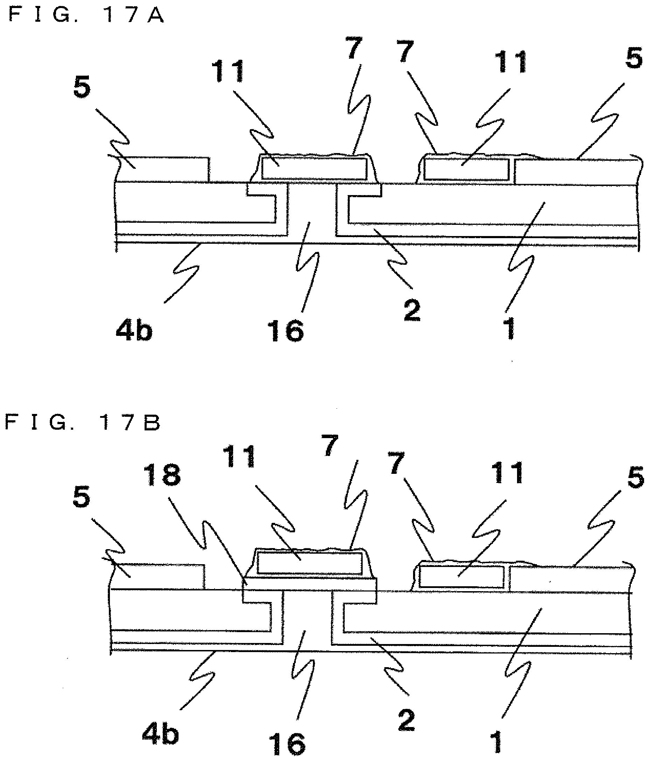

Examples of the back-contact type solar cell are shown in Figs. 16, 17A and 17B. As shown in Figs. 16, 17A and 17B, the back-contact type solar cell may have a configuration in which the semiconductor substrate 9 is provided with a large number of through-holes and the inner wall of the through-hole is also provided with a second semiconductor portion 2 arranged on the light-receiving surface side to connect a through-hole conductor 16 to this second semiconductor portion 2.

Alternatively, as shown in Fig. 17A, a wiring conductor 11 covered with solder 7 may be connected to the through-hole conductor 16 on the second surface 10b side by ultrasonic soldering, and the wiring conductor 11 covered with the solder may be connected to a conductor arrangement region 8 produced on the semiconductor substrate 9 as in the embodiment described above.

In addition to the configuration shown in Fig. 17A, as shown in Fig. 17B, a configuration in which a through-hole conductor 16 and a wiring conductor 11 covered with solder 7 are electrically connected to each other through a relay electrode 18 made of, for example, silver or copper produced on the through-hole conductor 16 by firing a conductive paste may be employed.

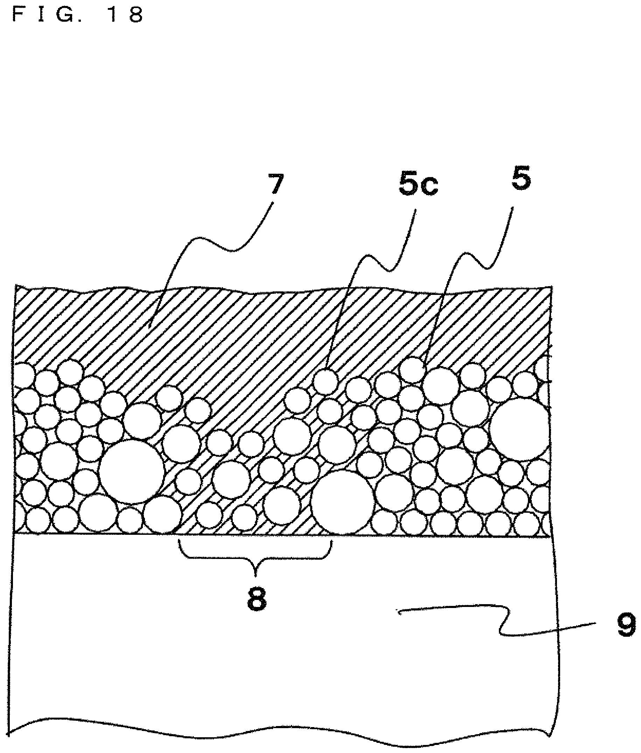

Furthermore, as shown in Fig. 18, the solar cell 10 of this embodiment may have a dense region where metal grains 5c constituting the second electrode 5 are densely present and a sparse region where the metal grains 5c are sparsely present on the semiconductor substrate 9 on the second surface 10b side of the solar cell 10. In such a configuration, the solder 7 penetrates into the sparse region and bonds to the semiconductor substrate 9. In the conductor arrangement region 8, the metal grains 5c and the solder 7 are mixed such that the surfaces of the metal grains 5c are covered with the solder 7. Since the solder 7 connects the individual metal grains 5c, the ohmic loss in the second electrode 5 can be reduced. Also in the dense region where the metal grains 5c are densely present, in the area near the interface of the solder 7 and the second electrode 5, the metal grains 5c and the solder 7 may be mixed such that the surfaces of the metal grains 5c are covered with the solder 7 to bond the metal grains 5c to one another through the solder 7. By doing so, the ohmic loss in the second electrode 5 can be further reduced. In such a configuration, the height of the sparse region of the metal grains 5c may be larger than that of the dense region in the regions containing both the metal grains 5c and the solder 7. The region containing both the metal grains 5c and the solder 7 may contain agglomerates comprised of several metal grains 5c.

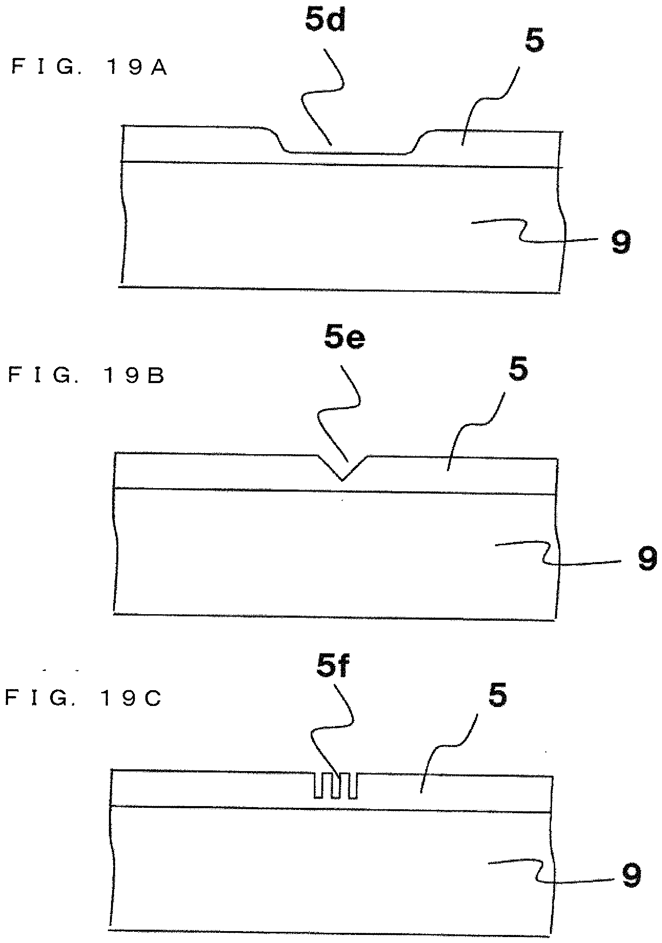

As shown in Fig. 18, in order to allow the solder 7 to penetrate into the second electrode 5 and bond to the semiconductor substrate 9, as shown in Fig. 19A, the thickness of a part of the second electrode 5 may be reduced to form a thin part 5d, before ultrasonic soldering. The thin part 5d may be formed by screen-printing a conductive paste (e.g., aluminum paste) such that the thickness of the metal mask of the printer is thin at the portion where the thickness of the second electrode 5 is reduced. Alternatively, the thin part 5d can be formed by reducing the discharge quantity of the conductive paste with a mesh-like (porous) metal mask.

The cross-sectional shape having a reduced thickness at a part of the second electrode 5 may be formed by, as shown in Fig. 19B, forming the second electrode 5 and then mechanically forming, for example, a V-groove by, for example, cutting a part of the surface of the second electrode 5 into a groove 5e to reduce the thickness of the part of the second electrode 5. On this occasion, a part of the second electrode 5 may be cut such that the groove 5e reaches the surface of the semiconductor substrate 9. In such a case, a plurality of grooves 5e may be formed. The strength can be increased by forming a large number of narrow grooves. The mechanical procedure such as cutting can readily control the thickness compared to printing.

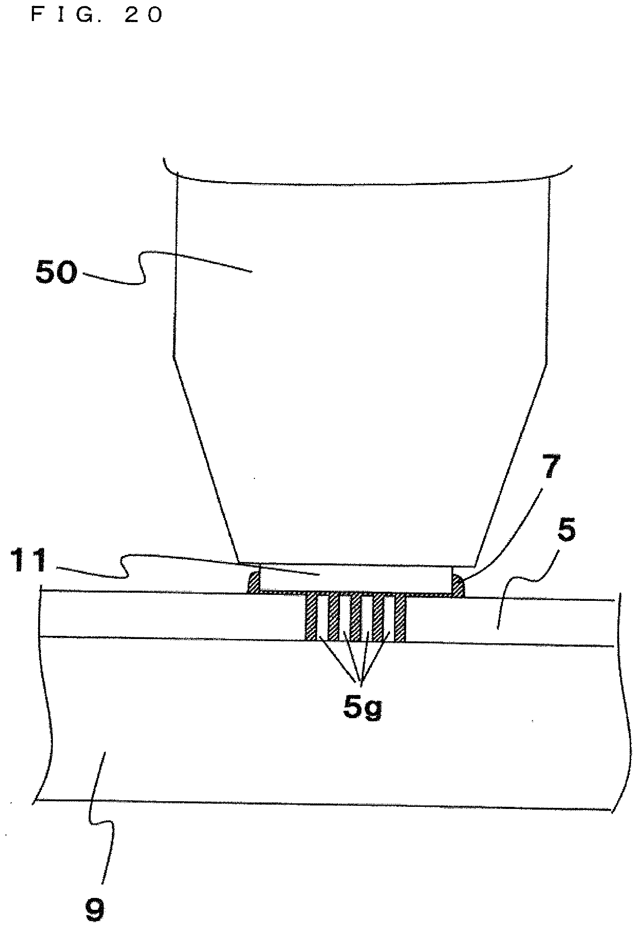

The cross-sectional shape having a reduced thickness at a part of the second electrode 5 may be formed by, as shown in Fig. 19C, forming the second electrode 5 and then forming repeating concave/convex (comb-like) portion 5f at a part of the second electrode 5. Such a shape can be formed by the same method as that for forming the thin part 5d or groove 5e. The flatness of the surface of the second electrode 5 can be enhanced by forming the repeating concave/convex portion 5f. As shown in Fig. 20, this prevents the trouble that the soldering iron 50 or solder wire is locked at the thin part of the second electrode 5 and thereby stops its movement during ultrasonic soldering. Consequently, a complicated mechanism for moving the soldering iron 50 up and down along the height direction of the second electrode 5 is unnecessary. In addition, also in provision of the wiring conductor 11, the workability of soldering is improved and unnecessary stress is prevented from being applied to the wiring conductor 11 as the flatness of at the concave/convex portion 5g of the second electrode 5 increases. Consequently, the occurrence of a crack in the solar cell 10 can be reduced.

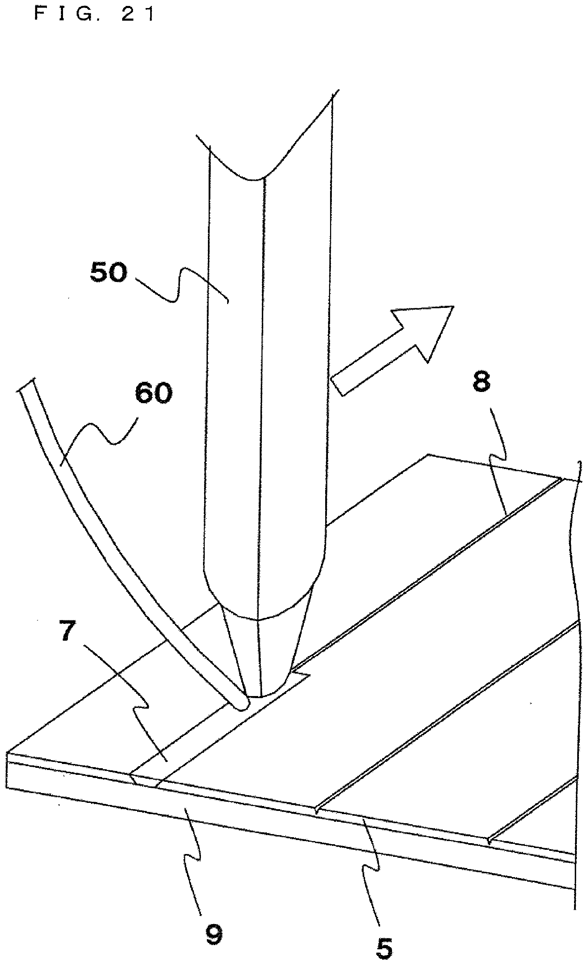

The second electrode 5 is formed by firing the conductive paste applied so as to include a portion having a reduced thickness as described above. Subsequently, as shown in Fig. 21, ultrasonic soldering is performed. In the ultrasonic soldering, it is believed that the metal grains (e.g., aluminum grains) bonded to one another during sintering of the second electrode 5 are separated into each grain by the impact in collapse of cavitation generated by ultrasonic vibration of the soldering iron 50 and that as shown in Fig. 18, the solder 7 penetrates into the gaps between metal grains 5c to form the region including both the metal grains 5c and the solder 7. In addition, in the region where the thickness of the second electrode 5 is small, the distance between the surface of the second electrode 5 and the soldering iron 50 is large to increase the amount of the solder present between the second electrode 5 and the soldering iron 50, resulting in an increase of cavitation. Consequently, as shown in Fig. 18, solder 7 reaches the surface of the semiconductor substrate 9 and thereby strongly bonds to the semiconductor substrate 9. For example, in a case using aluminum as the second electrode 9 and using a silicon substrate as the semiconductor substrate 5, a BSF region is formed at the surface of the semiconductor substrate 9 when the second electrode 5 is formed. The BSF region is therefore formed at the portion where the semiconductor substrate 9 is bonded to the solder 7, which allows the area of the BSF region to be broadened.

In a case using aluminum as the second electrode 5 and using a silicon substrate as the semiconductor substrate 9, a layer of an alloy such as an alloy of aluminum and silicon may be formed between the second electrode 5 and the semiconductor substrate 9. The solder 7 and the semiconductor substrate 9 may be strongly bonded to each other with the alloy layer. In particular, an alloy layer containing aluminum and silicon reduces the ohmic loss to advantageously improve the photoelectric conversion efficiency.

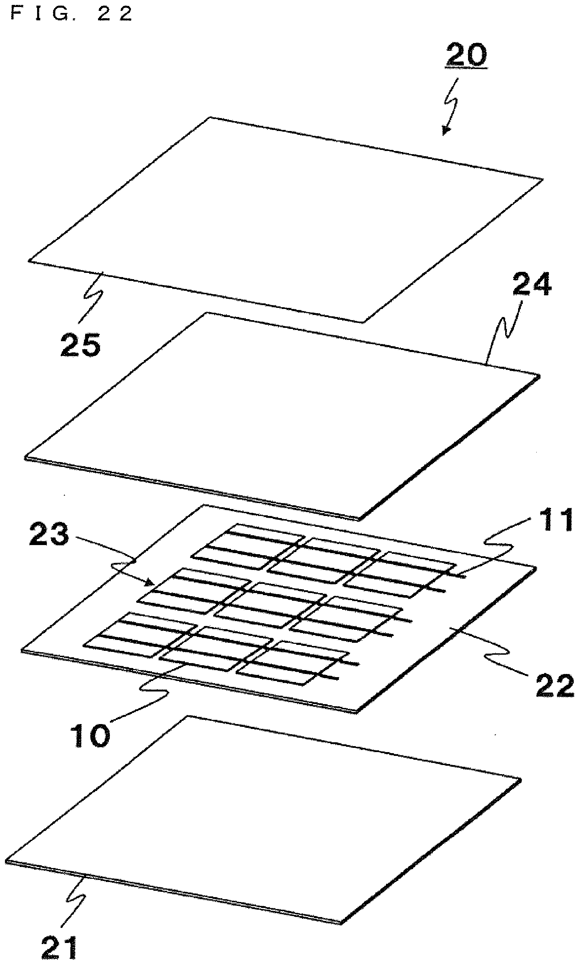

As shown in Fig. 22, the solar cell of the embodiment can also be applied to a solar cell module 20. As shown in Fig. 22, for example, one solar cell (solar cell element) 10 described above or a plurality of solar cell element strings 23, as shown in Fig. 22, each comprised of a plurality of the solar cells (solar cell elements) 10 electrically series-connected with the wiring conductor 11 may be sealed on a transparent support substrate 21 such as a glass or resin substrate with a first sealant 22 and a second sealant 24 having good moisture resistance, such as ethylene vinyl acetate (EVA). Furthermore, a back surface sheet 25 made of, for example, polyethylene terephthalate (PET) or polyvinyl fluoride resin (PVF) may be disposed on the second sealant 24. Furthermore, a frame of a metal, resin, or another material may be disposed on the periphery of the support substrate 21.

### EXAMPLES

Examples of the embodiment will now be described. A semiconductor substrate 9 having a p-type first semiconductor portion 1 was prepared using a polycrystalline silicon substrate having a thickness of 260 µm, an external size of 156 × 156 mm, and a specific resistance of 1.5 Ω·cm, and the damage layer on the surface of the semiconductor substrate 9 was etched with a NaOH solution, followed by washing.

Subsequently, texture was formed on the first surface 10a side of the semiconductor substrate 9 by wet etching method using hydrofluoric acid and nitric acid. A second semiconductor portion 2 was formed by a vapor-phase thermal diffusion method using POCl₃ as a diffusion source. The thus-prepared semiconductor substrate 9 was subjected to removal of phosphorus glass by etching with a hydrofluoric acid solution and pn-junction isolation with lasers. Subsequently, a silicon nitride film serving as an antireflection layer 3 was formed on the first surface 10a side of the semiconductor substrate 9 by PECVD method.

Furthermore, a BSF region 6 and a second electrode 5 were formed by applying an aluminum paste to the region for forming the second electrode 5 shown in Fig. 9 on the second surface 10b side of the semiconductor substrate 9 and firing the paste. A first electrode 4 was formed by applying a silver paste onto the first surface 10a and firing the paste.

Subsequently, in sample 1, a solder 7 was formed by ultrasonic soldering so as to cover the rectangular conductor arrangement regions 8 each having a width of 2 mm and a length of 4 mm and the second electrode 5 between the conductor arrangement regions 8 aligned in line in the up and down direction in Fig. 9. The solder 7 used herein had an alloy composition ratio (mass ratio) of tin to zinc of 96:4. The ultrasonic soldering was performed under conditions of an ultrasonic oscillation frequency of 60 kHz, an ultrasonic oscillation output of 3 W, and a heating temperature of 350°C. A wiring conductor 11, which was copper foil entirely covered with solder having the same alloy composition as that of the solder 7 used above, was welded onto the solder 7 with a soldering iron.

In sample 2 for comparison, a silver paste (containing 5% by mass of glass frit based on 100% by mass of silver powder) was applied instead of the solder so as to cover the conductor arrangement regions 8 each having the same shape and size as those of sample 1 and the second electrode 5 between the conductor arrangement regions 8 aligned in line in the up and down direction in Fig. 8, and the paste was fired to form an electrode for connecting a wiring conductor 11 as in sample 1. A flux was applied onto the electrode, and a wiring conductor 11, which was copper foil entirely covered with solder having the same alloy composition as that of the solder 7 used in sample 1, was welded onto the electrode with a soldering iron.

In sample 3 for comparison, a second electrode 5 was disposed in almost the entire region on the back surface side of the semiconductor substrate 9 without providing the conductor arrangement region 8. Solder 7 was formed so as to cover the second electrode 5 in the regions having the same shape and size as those of the conductor arrangement region 8 in sample 1 by ultrasonic soldering. A wiring conductor 11, which was copper foil entirely covered with solder having the same alloy composition as that of the solder used in sample 1, was welded onto the solder 7 with a soldering iron.

The adhesive strength of the wiring conductor 11 of each of Samples 1 to 3 was measured with a tensile strength tester.

The results were that the adhesive strength of sample 1 was 3.43 N, whereas the adhesive strengths of samples 2 and 3 were 1.96 N and 1.86 N, respectively. Thus, the adhesive strength was considerably improved.

### Reference Signs List

- 1: first semiconductor portion
- 2: second semiconductor portion
- 3: antireflection layer
- 4: first electrode
- 5: second electrode
- 6: BSF region
- 7: solder
- 8: conductor arrangement region
- 9: semiconductor substrate
- 10: solar cell element
- 10a: first surface
- 10b: second surface
- 11: wiring conductor

## Claims

1. A solar cell (10) comprising:
a semiconductor substrate (9),
a back-side electrode (5) arranged in a region excluding at least a predetermined conductor arrangement region (8) in the back surface of the semiconductor substrate (9),
wherein the predetermined conductor arrangement region (8) has a plurality of penetration portions aligned in a line, and
wherein the penetration portions are empty portions of the back-side electrode (5);
**characterized by** solder (7) adhering to the back surface of the semiconductor substrate (9) in the conductor arrangement region (8) and to the back-side electrode (5),
wherein the predetermined conductor arrangement region (8) is a portion where the solder (7) is in contact with the semiconductor substrate (9).

2. The solar cell (10) according to Claim 1, wherein the solder (7) is adhered to a side surface of the back-side electrode facing the conductor arrangement region (8), without adhering to an upper surface of the back-side electrode.

3. The solar cell (10) according to Claim 1, wherein the solder (7) is adhered to the upper surface of the back-side electrode and the side surface of the back-side electrode facing the conductor arrangement region (8).

4. The solar cell (10) according to any one of Claims 1 to 3, wherein
the back-side electrode contains aluminum as a main component, and
an alloy layer containing the aluminum is present at the region where the solder (7) and the back-side electrode are bonded to each other.

5. The solar cell (10) according to any one of Claims 1 to 4, wherein the solder (7) contains an alloy of tin and lead or an alloy of tin and zinc.

6. The solar cell (10) according to Claim 5, wherein the solder (7) further contains antimony.

7. The solar cell (10) according to any one of Claims 1 to 4, wherein the solder contains an alloy of tin, silver, and bismuth.

8. The solar cell (10) according to any one of Claims 1 to 7, wherein the semiconductor substrate (9) contains silicon as a main component.

9. The solar cell (10) according to any one of Claims 1 to 8, wherein the conductor arrangement region (8) includes a long region extending from one end of the back-side electrode to a predetermined position of the back-side electrode in a planar view.

10. The solar cell according to any one of Claims 1 to 9, wherein the width of the conductor arrangement region at a portion on one end side of the back-side electrode is larger than that of another portion.

11. The solar cell according to any one of Claims 1 to 10, further comprising a wiring conductor (11) disposed on the solder.

12. The solar cell according to claim 11, wherein a frontside electrode is disposed on the surface on the opposite side of the back surface of the semiconductor substrate (9) so as to overlap the wiring conductor (11) in a planar perspective view.

13. A method of manufacturing a solar cell (10), the method comprising:
preparing a semiconductor substrate (9);
forming a back-side electrode (5) having empty portions through which the back surface of the semiconductor substrate (9) is exposed in a region excluding at least a predetermined conductor arrangement region (8) in the back surface of the semiconductor substrate (9); and
soldering in the empty portions by bringing solder (7) into contact with the back surface of the semiconductor substrate (9) exposed in the empty portions and with the back-side electrode (5) and performing ultrasonic soldering for adhesion of the solder (7) to the back surface of the semiconductor substrate (9) exposed in the empty portions and the back-side electrode (5),
wherein the predetermined conductor arrangement region (8) has a plurality of penetration portions aligned in a line,
wherein the penetration portions are the empty portions of the back-side electrode (5), and
wherein the predetermined conductor arrangement region (8) is a portion where the solder (7) is in contact with the semiconductor substrate (9).

14. The method of manufacturing a solar cell (10) according to Claim 13, wherein the soldering is performed by arranging a wiring conductor (11) in the empty portions and then bringing solder (7) into contact with the wiring conductor (11), the semiconductor substrate (9) exposed in the empty portions and the back-side electrode (5) and performing the ultrasonic soldering for adhesion of the solder (7) to the wiring conductor (11), the semiconductor substrate (9) exposed in the empty portions and the back-side electrode (5).

## Patentansprüche

1. Eine Solarzelle (10), aufweisend:
ein Halbleitersubstrat (9),
eine Rückseitenelektrode (5), die in einem Bereich, ausgenommen mindestens einen vorbestimmten Leiter-Anordnungs-Bereich (8) in der rückwärtigen Fläche des Halbleitersubstrats (9), angeordnet ist,
wobei der vorbestimmte Leiter-Anordnungs-Bereich (8) eine Mehrzahl von Durchdringungsabschnitten aufweist, die in einer Linie ausgerichtet sind, und
wobei die Durchdringungsabschnitte leere Abschnitte der Rückseitenelektrode (5) sind;
**dadurch gekennzeichnet, dass** Lot (7) an der rückwärtigen Fläche des Halbleitersubstrats (9) im Leiter-Anordnungs-Bereich (8) und an der Rückseitenelektrode (5) haftet,
wobei der vorbestimmte Leiter-Anordnungs-Bereich (8) ein Abschnitt ist, wo das Lot (7) mit dem Halbleitersubstrat (9) in Kontakt ist.

2. Die Solarzelle (10) gemäß Anspruch 1, wobei das Lot (7) an einer Seitenfläche der Rückseitenelektrode haftet, die dem Leiter-Anordnungs-Bereich (8) zugewandt ist, ohne an einer oberen Fläche der Rückseitenelektrode zu haften.

3. Die Solarzelle (10) gemäß Anspruch 1, wobei das Lot (7) an der oberen Fläche der Rückseitenelektrode und der Seitenfläche der Rückseitenelektrode haftet, die dem Leiter-Anordnungs-Bereich (8) zugewandt ist.

4. Die Solarzelle (10) gemäß irgendeinem der Ansprüche 1 bis 3, wobei
die Rückseitenelektrode Aluminium als eine Hauptkomponente enthält und
eine Legierungsschicht, die das Aluminium enthält, an dem Bereich vorliegt, wo das Lot (7) und die Rückseitenelektrode miteinander verbunden sind.

5. Die Solarzelle (10) gemäß irgendeinem der Ansprüche 1 bis 4, wobei das Lot (7) eine Legierung aus Zinn und Blei oder eine Legierung aus Zinn und Zink enthält.

6. Die Solarzelle (10) gemäß Anspruch 5, wobei das Lot (7) ferner Antimon enthält.

7. Die Solarzelle (10) gemäß irgendeinem der Ansprüche 1 bis 4, wobei das Lot eine Legierung aus Zinn, Silber und Wismut enthält.

8. Die Solarzelle (10) gemäß irgendeinem der Ansprüche 1 bis 7, wobei das Halbleitersubstrat (9) Silicium als eine Hauptkomponente enthält.

9. Die Solarzelle (10) gemäß irgendeinem der Ansprüche 1 bis 8, wobei der Leiter-Anordnungs-Bereich (8) einen langen Bereich aufweist, der sich in einer Draufsicht von einem Ende der Rückseitenelektrode zu einer vorbestimmten Position der Rückseitenelektrode erstreckt.

10. Die Solarzelle gemäß irgendeinem der Ansprüche 1 bis 9, wobei die Breite des Leiter-Anordnungs-Bereichs an einem Abschnitt auf einer Endseite der Rückseitenelektrode größer als die eines anderen Abschnitts ist.

11. Die Solarzelle gemäß irgendeinem der Ansprüche 1 bis 10, ferner aufweisend einen Verdrahtungsleiter (11), der auf dem Lot angeordnet ist.

12. Die Solarzelle gemäß Anspruch 11, wobei eine Vorderseitenelektrode auf der Oberfläche auf der zu der rückwärtigen Fläche entgegengesetzten Seite des Halbleitersubstrats (9) angeordnet ist, um in einer perspektiven Draufsicht mit dem Verdrahtungsleiter (11) überlappt zu sein.

13. Ein Verfahren zum Herstellen einer Solarzelle (10), wobei das Verfahren aufweist:
Bereitstellen eines Halbleitersubstrats (9),
Ausbilden einer Rückseitenelektrode (5), die leere Abschnitte aufweist, durch die hindurch die rückwärtige Fläche des Halbleitersubstrats (9) freiliegt, in einem Bereich ausgenommen mindestens einen vorbestimmten Leiter-Anordnungs-Bereich (8) in der rückwärtigen Fläche des Halbleitersubstrats (9), und
Löten in den leeren Abschnitten durch in-Kontakt-Bringen von Lot (7) mit der rückwärtigen Fläche des Halbleitersubstrats (9), die in den leeren Abschnitten freiliegt, und mit der Rückseitenelektrode (5) und Durchführen von Ultraschalllöten, damit das Lot (7) an der rückwärtigen Fläche des Halbleitersubstrats (9), die in den leeren Abschnitten freiliegt, und der Rückseitenelektrode (5) haftet,
wobei der vorbestimmte Leiter-Anordnungs-Bereich (8) eine Mehrzahl von Durchdringungsabschnitten aufweist, die in einer Linie ausgerichtet sind,
wobei die Durchdringungsabschnitte die leeren Abschnitte der Rückseitenelektrode (5) sind und
wobei der vorbestimmte Leiter-Anordnungs-Bereich (8) ein Abschnitt ist, wo das Lot (7) mit dem Halbleitersubstrat (9) in Kontakt ist.

14. Das Verfahren zum Herstellen einer Solarzelle (10) gemäß Anspruch 13, wobei das Löten durchgeführt wird durch Anordnen eines Verdrahtungsleiters (11) in den leeren Abschnitten und anschließendes in-Kontakt-Bringen von Lot (7) mit dem Verdrahtungsleiter (11), dem in den leeren Abschnitten freiliegenden Halbleitersubstrat (9) und der Rückseitenelektrode (5), und durch Durchführen des Ultraschalllötens, damit das Lot (7) an dem Verdrahtungsleiter (11), dem in den leeren Abschnitten freiliegenden Halbleitersubstrat (9) und der Rückseitenelektrode (5) haftet.

## Revendications

1. Une cellule solaire (10), comportant :
un substrat semi-conducteur (9),
une électrode arrière (5) disposée dans une zone sauf au moins une zone d'agencement de conducteur prédéterminée (8) dans la surface arrière du substrat semi-conducteur (9),
dans laquelle la zone d'agencement de conducteur prédéterminée (8) a une pluralité de parties de pénétration alignées en ligne, et
dans laquelle les parties de pénétration sont des parties vides de l'électrode arrière (5),
**caractérisée par** de la soudure (7) adhérant à la surface arrière du substrat semi-conducteur (9) dans la zone d'agencement de conducteur (8) et à l'électrode arrière (5),
dans laquelle la zone d'agencement de conducteur prédéterminée (8) est une partie où la soudure (7) est en contact avec le substrat semi-conducteur (9).

2. La cellule solaire (10) selon la revendication 1, dans laquelle la soudure (7) est adhérée à une surface latérale de l'électrode arrière tournée vers la zone d'agencement de conducteur (8), sans adhérant à une surface supérieure de l'électrode arrière.

3. La cellule solaire (10) selon la revendication 1, dans laquelle la soudure (7) est adhérée à la surface supérieure de l'électrode arrière et la surface latérale de l'électrode arrière tournée vers la zone d'agencement de conducteur (8).

4. La cellule solaire (10) selon l'une quelconque des revendications 1 à 3, dans laquelle
l'électrode arrière comprend de l'aluminium comme composant principal et
une couche d'alliage comprenant l'aluminium est présente dans la zone où la soudure (7) et l'électrode arrière sont reliées l'une à l'autre.

5. La cellule solaire (10) selon l'une quelconque des revendications 1 à 4, dans laquelle la soudure (7) comprend un alliage d'étain et de plomb ou un alliage d'étain et de zinc.

6. La cellule solaire (10) selon la revendication 5, dans laquelle la soudure (7) comprend en outre de l'antimoine.

7. La cellule solaire (10) selon l'une quelconque des revendications 1 à 4, dans laquelle la soudure comprend un alliage d'étain, d'argent et de bismuth.

8. La cellule solaire (10) selon l'une quelconque des revendications 1 à 7, dans laquelle le substrat semi-conducteur (9) comprend du silicium comme composant principal.

9. La cellule solaire (10) selon l'une quelconque des revendications 1 à 8, dans laquelle la zone d'agencement de conducteur (8) comprend une zone longue s'étendant à partir d'une extrémité de l'électrode arrière à une position prédéterminée de l'électrode arrière dans une vue en plan.

10. La cellule solaire selon l'une quelconque des revendications 1 à 9, dans laquelle la largeur de la zone d'agencement de conducteur à une partie sur un côté d'extrémité de l'électrode arrière est supérieure à celle d'une autre partie.

11. La cellule solaire selon l'une quelconque des revendications 1 à 10, comportant en outre un conducteur de câblage (11) disposé sur la soudure.

12. La cellule solaire selon la revendication 11, dans laquelle une électrode avant est disposée sur la surface du côté opposé de la surface arrière du substrat semi-conducteur (9) de manière à chevaucher le conducteur de câblage (11) dans une vue en plan en perspective.

13. Un procédé de fabrication d'une cellule solaire (10), le procédé comportant les étapes suivantes consistant à :
préparer un substrat semi-conducteur (9) ;
former une électrode arrière (5) ayant des parties vides au travers lesquelles la surface arrière du substrat semi-conducteur (9) est exposée dans une zone sauf au moins une zone d'agencement de conducteur prédéterminée (8) dans la surface arrière du substrat semi-conducteur (9) ; et
souder dans les parties vides en mettant de la soudure (7) en contact avec la surface arrière du substrat semi-conducteur (9) exposée dans les parties vides et avec l'électrode arrière (5) et en effectuant de la soudure ultrason pour l'adhésion de la soudure (7) à la surface arrière du substrat semi-conducteur (9) exposée dans les parties vides, et l'électrode arrière (5),
dans lequel la zone d'agencement de conducteur prédéterminée (8) a une pluralité de parties de pénétration alignées en ligne,
dans lequel les parties de pénétration sont les parties vides de l'électrode arrière (5), et
dans lequel la zone d'agencement de conducteur prédéterminée (8) est une partie où la soudure (7) est en contact avec le substrat semi-conducteur (9).

14. Le procédé de fabrication d'une cellule solaire (10) selon la revendication 13, dans lequel la soudure est effectuée an disposant un conducteur de câblage (11) dans les parties vides et puis en mettant de la soudure (7) en contact avec le conducteur de câblage (11), le substrat semi-conducteur (9) exposé dans les parties vides et l'électrode arrière (5), et en effectuant la soudure ultrason pour l'adhésion de la soudure (7) au conducteur de câblage (11), le substrat semi-conducteur (9) exposé dans les parties vides et l'électrode arrière (5).
